# EUROPÄISCHE PATENTANMELDUNG

(11) **EP 0 887 863 A2**
(43) Veröffentlichungstag der Anmeldung: **30.12.1998**
(21) Anmeldenummer: 98109132.5
(22) Anmeldetag: 19.05.1998
(51) Int. Cl.: H01L 27/108, H01L 21/8242

(54) **DRAM mit selbstverstärkenden Speicherzellen**

(30) Priorität: 27.06.1997 DE 19727466
(71) Anmelder: SIEMENS AKTIENGESELLSCHAFT, 80333 München (DE)
(72) Erfinder: Goebel, Bernd, 81735 München (DE); Bertagnolli, Emmerich, Dr., 80799 München (DE)

(57) **Zusammenfassung**

Die DRAM-Zellenanordnung umfaßt pro Speicherzelle drei Transistoren, von denen mindestens einer als vertikaler Transistor ausgebildet ist. Die Transistoren können an Flanken (1F1, 1F2, 2F2) von Gräben (G1, G2) ausgebildet sein. Zur Herstellung von Kontaktgebieten (K), die jeweils drei Source/Drain-Gebiete (1 S/D1, 3 S/D2, 2 S/D2) verschiedener Transistoren miteinander verbinden, ist es vorteilhaft, die Gräben (G1, G2) alternierend mit einem größeren Abstand und einem kleineren Abstand voneinander anzuordnen. Gateelektroden (Ga1, Ga3) von Transistoren können als Teile von schreibenden Wortleitungen (WS) oder auslesenden Wortleitungen (WA) in Form von Spacern an Flanken (1F1, 1F2) der Gräben (G1) gebildet sein. Verbindungen zwischen Gateelektroden (Ga2) und Source/Drain-Gebieten (3 S/D1) können über leitende Strukturen (L) erfolgen.

## Beschreibung

Die Erfindung betrifft eine DRAM-Zellenanordnung, d.h. eine Speicherzellen-Anordnung mit dynamischem wahlfreiem Zugriff, bei der eine Speicherzelle drei Transistoren umfaßt.

In DRAM-Zellenanordnungen werden derzeit fast ausschließlich sogenannte Eintransistor-Speicherzellen eingesetzt. Eine Eintransistor-Speicherzelle umfaßt einen Auslesetransistor und einen Speicherkondensator. In dem Speicherkondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden. Die im Speicherkondensator gespeicherte elektrische Ladung treibt dabei die Bitleitung.

Da von Speichergeneration zu Speichergeneration die Speicherdichte zunimmt, muß die benötigte Fläche der Eintransistor-Speicherzelle von Generation zu Generation reduziert werden. Dies führt zu grundlegenden technologischen und physikalischen Problemen. Beispielsweise muß der Speicherkondensator trotz kleinerer Fläche der Eintransistor-Speicherzelle eine Mindestmenge an elektrischer Ladung speichern können, um damit die Bitleitung treiben zu können.

Dieses Problem wird in einer alternativen DRAM-Zellenanordnung, in der als Speicherzellen sog. Gainzellen eingesetzt werden, umgangen. Auch hier ist die Information in Form einer elektrischen Ladung gespeichert. Die elektrische Ladung muß jedoch nicht direkt eine Bitleitung treiben, sondern wird in einer Gateelektrode eines Transistors gespeichert und dient nur zu dessen Steuerung, wozu schon eine sehr kleine Menge an elektrischer Ladung genügt.

In Microelectronic Engineering 15 (1991) Seiten 367-370 wird eine Gainzelle, die drei Bauelemente, nämlich einen ersten Transistor, einen zweiten Transistor und eine Diode, umfaßt, beschrieben. Die elektrische Ladung wird in einer zweiten Gateelektrode des zweiten Transistors gespeichert. Das Speichern der elektrischen Ladung geschieht mit Hilfe des ersten Transistors und der Diode. Dazu ist die zweite Gateelektrode mit der Diode, die Diode mit einem zweiten Source/Drain-Gebiet des zweiten Transistors und mit einem ersten Source/Drain-Gebiet des ersten Transistors, ein erstes Source/Drain-Gebiet des zweiten Transistors mit einer Spannungsquelle und ein zweites Source/Drain-Gebiet des ersten Transistors mit einer Bitleitung verbunden. Zum Speichern wird eine erste Gateelektrode des ersten Transistors über eine Wortleitung angesteuert. Die Menge an elektrischer Ladung und damit die Information, die dabei in der zweiten Gateelektrode gespeichert wird, wird durch eine Spannung an der Bitleitung bestimmt. Die Diode ist dabei in Durchlaßrichtung gepolt. Das Auslesen der Information geschieht durch Ansteuerung der ersten Gateelektrode des ersten Transistors über die Wortleitung. Die Menge an elektrischer Ladung und damit die Information, die dabei in der zweiten Gateelektrode gespeichert ist, bestimmt, ob in der Bitleitung Strom fließt oder nicht. Die Diode ist dabei in Sperrrichtung gepolt.

Der Erfindung liegt das Problem zugrunde, eine DRAM-Zellenanordnung anzugeben, die als Speicherzellen Gainzellen mit jeweils mindestens drei Bauelementen umfaßt und mit besonders hoher Packungsdichte herstellbar ist. Ferner soll ein Herstellungsverfahren für eine solche DRAM-Zellenanordnung angegeben werden.

Dieses Problem wird gelöst durch eine DRAM-Zellenanordnung gemäß Anspruch 1 sowie ein Verfahren zu deren Herstellung gemäß Anspruch 9. Weitere Ausgestaltungen der Erfindung gehen aus den übrigen Ansprüchen hervor.

In einer erfindungsgemäßen DRAM-Zellenanordnung sind drei Bauelemente einer Speicherzelle Transistoren, von denen mindestens einer als ein vertikaler Transistor ausgebildet ist. Es ist vorteilhaft, alle drei Transistoren der Speicherzelle als vertikale Transistoren auszubilden, da die Fläche der Speicherzelle dadurch besonders klein wird.

Es liegt im Rahmen der Erfindung, die drei Transistoren an Flanken eines ersten Grabens und eines zweiten Grabens, die innerhalb eines Substrats im wesentlichen zueinander parallel verlaufen, auszubilden. Die Verbindung einer Gateelektrode eines zweiten Transistors (im folgenden auch als 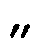 zweite Gateelektrode" bezeichnet), in der eine Information gespeichert wird, mit einem ersten Source/Drain-Gebiet des dritten Transistors erfolgt beispielsweise über eine leitende Struktur, die beispielsweise oberhalb einer Oberfläche des Substrats das erste Source/Drain-Gebiet des dritten Transistors und die zweite Gateelektrode überlappt. Die leitende Struktur kann auch Elemente umfassen, die innerhalb des zweiten Grabens angeordnet sind und an die zweite Gateelektrode angrenzen. Das erste Source/Drain-Gebiet des dritten Transistors kann auch direkt an die zweite Gateelektrode angrenzen. In diesem Fall wird auf die leitende Struktur verzichtet.

Damit entlang Flanken der ersten Gräben und der zweiten Gräben zwischen benachbarten, von einem ersten Leitfähigkeitstyp dotierten Source/Drain-Gebieten verschiedener Transistoren keine Ströme fließen, können durch schräge Implantation an den Flanken der ersten Gräben und der zweiten Gräben zwischen den Transistoren hochdotierte Channel-Stop-Gebiete erzeugt werden. Die Channel-Stop-Gebiete sind von einem zweiten, zum ersten Leitfähigkeitstyp entgegengesetzten Leitfähigkeitstyp dotiert.

Es liegt im Rahmen der Erfindung innerhalb des Substrats angrenzend an einen Boden des ersten Grabens und an einen Boden des zweiten Grabens ein Kontaktgebiet anzuordnen, das ein erstes Source/Drain-Gebiet eines ersten Transistors, ein zweites Source/Drain-Gebiet eines dritten Transistors und ein zweites Source/Drain-Gebiet des zweiten Transistors miteinander verbindet. Es ist vorteilhaft, wenn das erste Source/Drain-Gebiet des ersten Transistors, das zweite Source/Drain-Gebiet des dritten Transistors und das zweite Source/Drain-Gebiet des zweiten Transistors Teile des Kontaktgebiets sind. Für die Erzeugung des Kontaktgebiets ist es vorteilhaft, wenn der Abstand zwischen dem ersten Graben und dem zweiten Graben kleiner als Abstände zwischen ersten Gräben und zweiten Gräben verschiedener Speicherzellen ist. Dadurch lassen sich voneinander isolierte Kontaktgebiete ohne Masken durch Implantation erzeugen. Das Kontaktgebiet kann auch als eine dotierte Schicht oder als eine Schicht, die Metall enthält, realisiert werden, die mit dem ersten Source/Drain-Gebiet des ersten Transistors, dem zweiten Source/Drain-Gebiet des dritten Transistors und dem zweiten Source/Drain-Gebiet des zweiten Transistors verbunden ist.

Werden die Kanalgebiete durch Implantation erzeugt, so ist es vorteilhaft, vor der Implantation Flanken der ersten Gräben und der zweiten Gräben durch Abscheiden und Rückätzen von Material, z.B. SiO₂ mit Spacern zu versehen, um die Flanken vor Implantation zu schützen.

Zur Verkleinerung der Fläche der Speicherzelle ist es vorteilhaft, wenn der Abstand zwischen dem ersten Graben und dem zweiten Graben kleiner als die minimale, in der jeweiligen Technologie herstellbare Strukturgröße F ist. Dazu wird beim Ätzen des ersten Grabens und des Zweiten Grabens eine als Maske dienende isolierende Schicht verwendet, die mit Hilfe von ersten Spacern strukturiert und durch zweite Spacer modifiziert wurde.

Zur Verkleinerung der Fläche der Speicherzelle, ist es vorteilhaft, wenn ein zweites Source/Drain-Gebiet des ersten Transistors mit einem zweiten Source/Drain-Gebiet eines ersten Transistors einer ersten benachbarten Speicherzelle, und ein erstes Source/Drain-Gebiet des zweiten Transistors mit einem ersten Source/Drain-Gebiet eines zweiten Transistors einer zweiten benachbarten Speicherzelle zusammenfallen. Das bedeutet, daß benachbarte Speicherzellen bezüglich einer Achse, die parallel zu den ersten Gräben verläuft, spiegelsymmetrisch zueinander angeordnet sind.

Es ist vorteilhaft, eine schreibende Wortleitung und eine auslesende Wortleitung in Form von Spacern an den Flanken des ersten Grabens anzuordnen. Teile der schreibenden Wortleitung können als Gateelektroden von dritten Transistoren (im folgenden auch als 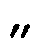 dritte Gateelektroden" bezeichnet) und Teile der auslesenden Wortleitung als Gateelektroden von ersten Transistoren (im folgenden auch als 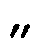 erste Gateelektroden" bezeichnet) wirken.

Zur Erzeugung der schreibenden Wortleitung und der auslesenden Wortleitung ist es vorteilhaft, nachdem der erste Graben und der Zweite Graben mit einem Gatedielektrikum versehen wurden, leitendes Material konform aufzubringen, den zweiten Graben mit leitendem Material zu füllen und anschließend das leitende Material rückzuätzen, bis an den Flanken des ersten Grabens die schreibende Wortleitung und die auslesende Wortleitung in Form von Spacern entstehen. Teile des leitenden Materials in den zweiten Gräben können mit Hilfe einer Maske entfernt werden. Ein übrigbleibender Teil des leitenden Materials im zweiten Graben ist als die zweite Gateelektrode des zweiten Transistors geeignet.

Es liegt im Rahmen der Erfindung zur Erzeugung einer leitenden Struktur, die das erste Source/Drain-Gebiet des dritten Transistors mit der zweiten Gateelektrode des zweiten Transistors verbindet, nach der Erzeugung der zweiten Gateelektrode des zweiten Transistors isolierendes Material aufzubringen und mit Hilfe einer Maske so zu strukturieren, daß ein Teil des ersten Source/Drain-Gebiets des dritten Transistors freigelegt wird. Die leitende Struktur kann z.B. durch selektive Silizierung erzeugt werden. Dazu wird ganzflächig Metall aufgebracht und anschließend getempert, wodurch auf dem freigelegten Teil des ersten Source/Drain-Gebiets des dritten Transistors und auf der zweiten Gateelektrode des zweiten Transistors Metallsilizid entsteht. Übrigbleibendes Metall wird durch einen Ätzschritt anschließend entfernt. Die leitende Struktur kann z.B. auch durch Aufbringen von leitendem Material, das anschließend zurückgeätzt oder chemisch-mechanisch poliert wird, erzeugt werden.

Es liegt im Rahmen der Erfindung zur Verbesserung verschiedener Eigenschaften der DRAM-Zellenanordnung, zusätzlich zu den drei Transistoren der Speicherzelle weitere Bauelemente, wie z.B. Kondensatoren, in die Speicherzelle zu integrieren.

Aufgrund von Leckströmen, muß die Information in regelmäßigen Zeitabständen neu auf die zweiten Gateelektroden geschrieben werden. Um die Zeitabstände zu vergrößern, ist es vorteilhaft, die Speicherzellen jeweils mit einem Kondensator zu versehen, dessen erste Kondensatorplatte mit der zweiten Gateelektrode verbunden ist.

Zum Programmieren der Speicherzelle werden der erste Transistor über die auslesende Wortleitung und der dritte Transistor über die schreibende Wortleitung angesteuert. Abhängig vom eingestellten Potential an einer Bitleitung, die mit einem zweiten Source/Drain-Gebiet des ersten Transistors verbunden ist, wird eine Ladung, die die Information darstellt, auf die Gateelektrode des zweiten Transistors aufgebracht. Zum Auslesen der Speicherzelle wird der erste Transistor über die auslesende Wortleitung angesteuert. Abhängig von der gespeicherten Ladung auf der Gateelektrode des zweiten Transistors, ist der zweite Transistor geöffnet oder nicht und es fließt Strom durch die Bitleitung oder nicht. Der erste Transistor und der zweite Transistor sind als Teile der Bitleitung in Reihe geschaltet. Die Bezeichnungen 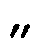 schreibende Wortleitung" und 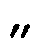 auslesende Wortleitung" sind nicht einschränkend zu verstehen.

Im folgenden werden Ausführungsbeispiele der Erfindung, die in den Figuren dargestellt sind, näher erläutert.
- Figur 1: zeigt einen Ausschnitt aus einer Oberfläche eines ersten Substrats. Die Oberfläche umfaßt zu einer x-Achse parallele streifenförmige horizontale Bereiche und zu einer y-Achse parallele streifenförmige vertikale Bereiche.
- Figur 2: zeigt einen Querschnitt parallel zur x-Achse und senkrecht zu der Oberfläche des in einer Schicht dotierten ersten Substrats, nachdem ein dotiertes Gebiet erzeugt wurde.
- Figur 3: zeigt den Querschnitt aus Figur 2, nachdem erste vorläufige Gräben, erste Spacer und streifenförmige Strukturen erzeugt wurden.
- Figur 4: zeigt den Querschnitt aus Figur 3 nachdem zweite vorläufige Gräben und zweite Spacer erzeugt wurden.
- Figur 5: zeigt den Querschnitt aus Figur 4, nachdem zweite Spacer entfernt wurden und erste Gräben und zweite Gräben erzeugt wurden. Aus dem dotierten Gebiet entstehen dabei zweite Source/Drain-Gebiete von ersten Transistoren, erste Source/Drain-Gebiete von zweiten Transistoren und erste Source/Drain-Gebiete von dritten Transistoren.

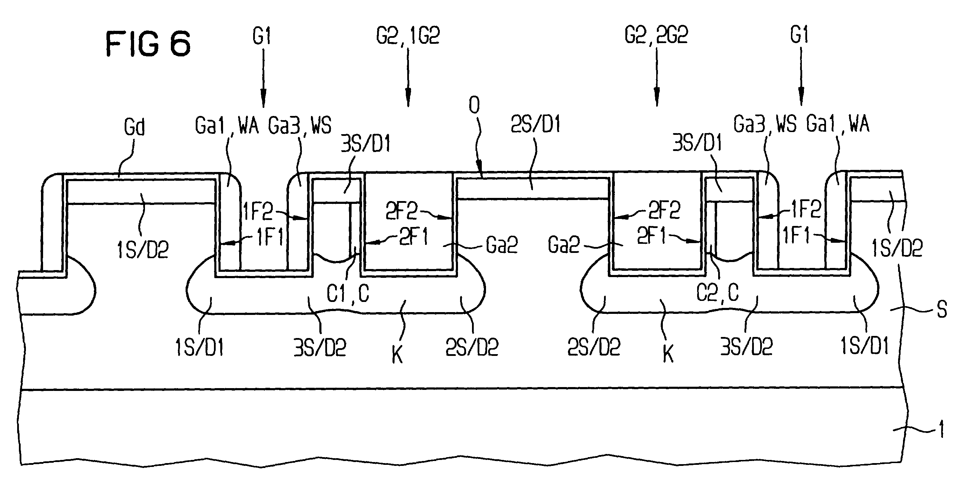

- Figur 6: zeigt den Querschnitt aus Figur 5, nachdem Kontaktgebiete, schreibende Wortleitungen, auslesende Wortleitungen, Channel-Stop-Gebiete, zweite Gateelektroden von zweiten Transistoren und ein Gatedielektrikum erzeugt wurden. Als Teile der auslesenden Wortleitungen wurden erste Gateelektroden von ersten Transistoren und als Teile der schreibenden Wortleitungen wurden dritte Gateelektroden von dritten Transistoren erzeugt. Als Teile der Kontaktgebiete wurden erste Source/Drain-Gebiete der ersten Transistoren zweite Source/Drain-Gebiete der zweiten Transistoren dritte Source/Drain-Gebiete der dritten Transistoren erzeugt.
- Figur 7: zeigt den Querschnitt aus Figur 6, nachdem erste isolierende Strukturen und leitende Strukturen erzeugt wurden.
- Figur 8: zeigt den Querschnitt aus Figur 7, nachdem zweite isolierende Strukturen, Kontakte von Bitleitungen und die Bitleitungen erzeugt wurden.

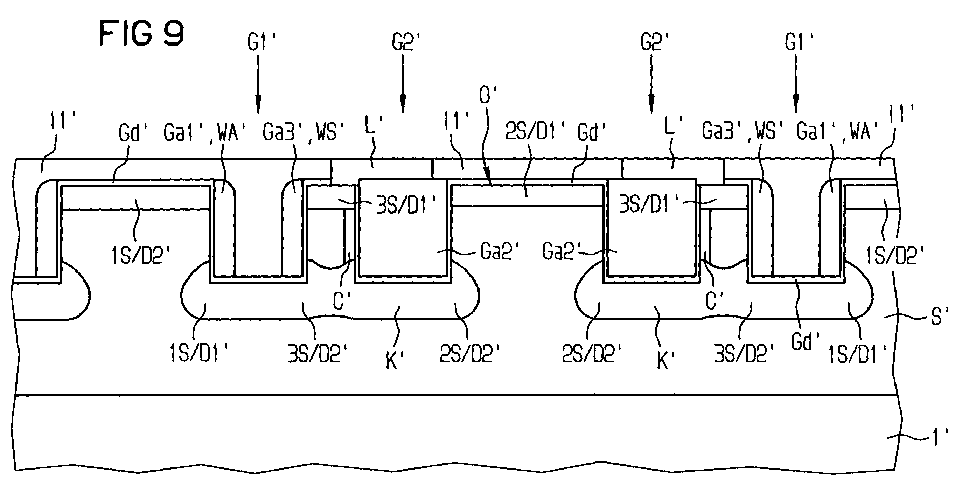

- Figur 9: zeigt einen Querschnitt senkrecht zu einer Oberfläche eines in einer Schicht dotierten zweiten Substrats, nachdem ein dotiertes Gebiet, erste Gräben, zweite Gräben, zweite Source/Drain-Gebiete von ersten Transistoren, erste Source/Drain-Gebiete von zweiten Transistoren und erste Source/Drain-Gebiete von dritten Transistoren, Kontaktgebiete, schreibende Wortleitungen, auslesende Wortleitungen, Channel-Stop-Gebiete, zweite Gateelektroden von zweiten Transistoren, ein Gatedielektrikum, erste Gateelektroden von ersten Transistoren, dritte Gateelektroden von dritten Transistoren, erste isolierende Strukturen und leitende Strukturen erzeugt wurden.

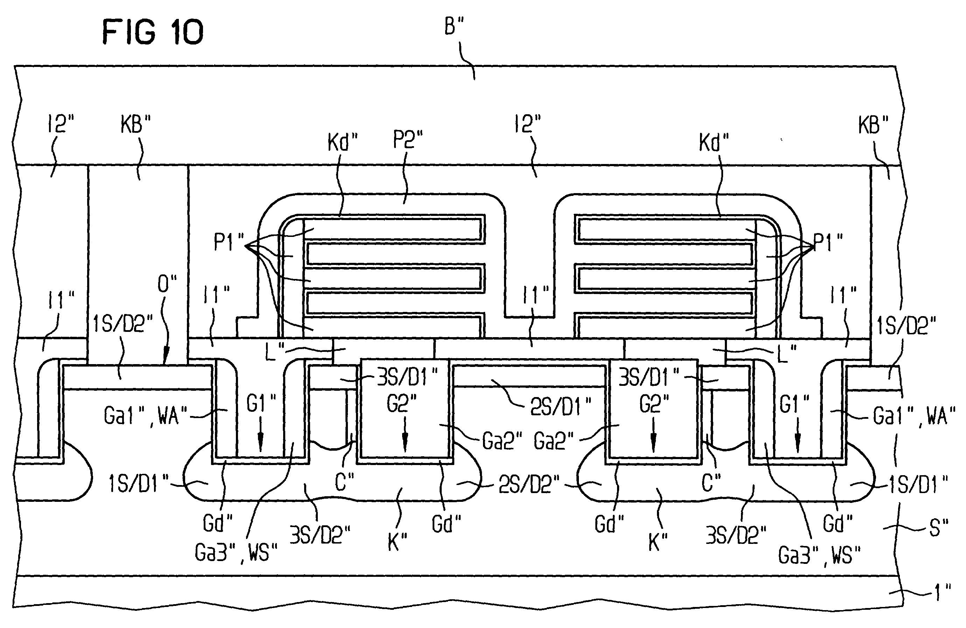

- Figur 10: zeigt einen Querschnitt senkrecht zu einer Oberfläche eines in einer Schicht dotierten dritten Substrats, nachdem ein dotiertes Gebiet, erste Graben, zweite Gräben, zweite Source/Drain-Gebiete von ersten Transistoren, erste Source/Drain-Gebiete von zweiten Transistoren und erste Source/Drain-Gebiete von dritten Transistoren, Kontaktgebiete, schreibende Wortleitungen, auslesende Wortleitungen, Channel-Stop-Gebiete, zweite Gateelektroden von zweiten Transistoren, ein Gatedielektrikum, erste Gateelektroden von ersten Transistoren, dritte Gateelektroden von dritten Transistoren, erste isolierende Strukturen, leitende Strukturen, erste Kondensatorplatten, Kondensatordielektrika, zweite Kondensatorplatten, zweite isolierende Strukturen, Kontakte von Bitleitungen und die Bitleitungen erzeugt wurden.
- Figur 11: zeigt wie Transistoren einer Speicherzelle, die im ersten Substrat erzeugt wurde, verschaltet sind.
- Figur 12: zeigt wie die Transistoren und ein Kondensator einer Speicherzelle, die im dritten Substrat erzeugt wurde, verschaltet sind.

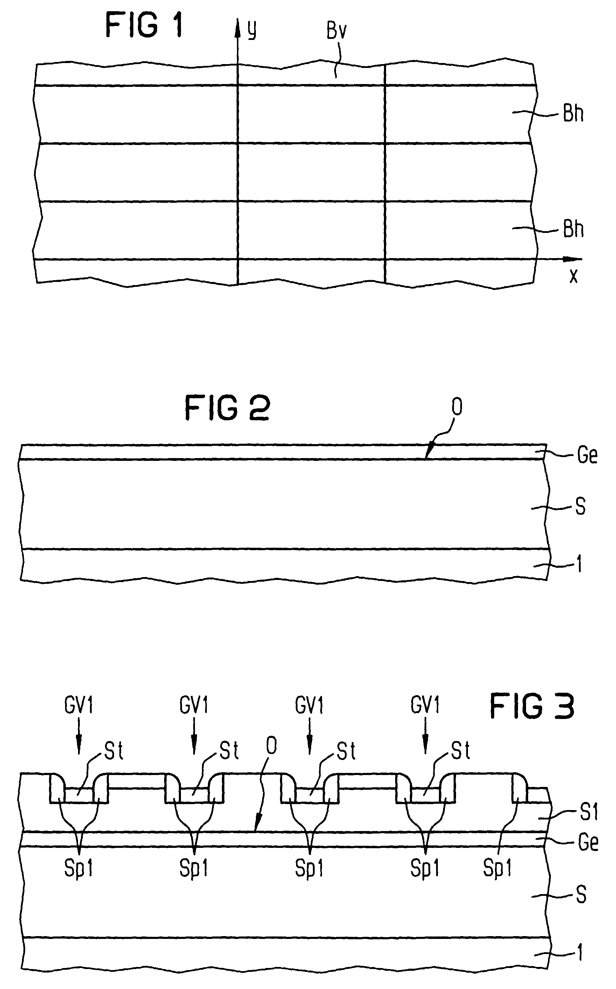

Gemäß eines ersten Ausführungsbeispiels ist ein erstes Substrat 1 aus Silizium in einer an eine Oberfläche O des ersten Substrats 1 angrenzenden ca. 2 µm dicken Schicht S, p-dotiert. Die Dotierstoffkonzentration beträgt ca. 10¹⁷cm⁻³. Eine x-Achse x und eine zur x-Achse x senkrechte y-Achse y verlaufen in der Oberfläche O (s. Fig 1). Die Oberfläche O umfaßt horizontale Bereiche Bh und vertikale Bereiche Bv. Die horizontalen Bereiche Bh sind streifenförmig, verlaufen parallel zur x-Achse x und haben eine Weite von ca. 500 nm. Der Abstand zwischen Mittellinien benachbarter horizontaler Bereiche Bh beträgt ca. 1000 nm. Die vertikalen Bereiche Bv sind streifenförmig, verlaufen parallel zur y-Achse y und haben eine Weite von ca. 1000 nm. Der Abstand von Mittellinien benachbarter vertikaler Bereiche Bv beträgt ca. 4000 nm. Mit Hilfe einer ersten Maske aus Fotolack (nicht dargestellt), die die horizontalen Bereiche Bh und die vertikalen Bereiche Bv nicht bedeckt, wird durch Implantation ein n-dotiertes ca. 150 nm tiefes Gebiet Ge erzeugt (siehe Figur 2). Die Dotierstoffkonzentration des Gebietes Ge beträgt ca. 5*x*10²⁰*cm*⁻³.

Auf die Oberfläche O wird eine ca. 600 nm dicke isolierende Schicht S1 aus *SiO*₂ abgeschieden. Mit Hilfe einer streifenförmigen zweiten Maske aus Fotolack (nicht dargestellt) werden durch anisotropes Ätzen parallel zueinander verlaufende erste vorläufige Gräben GV1 erzeugt (s. Fig. 3). Zum anisotropen Ätzen von SiO₂ ist z.B. CHF₃+O₂ geeignet. Eine Mittellinie eines der vorläufigen Gräben GV1 fällt mit einer Mittellinie eines der vertikalen Bereiche Bv zusammen. Der Abstand zwischen Mittellinien benachbarter erster vorläufiger Gräben GV1 beträgt ca. 1000 nm. Die ersten vorläufigen Gräben GV1 sind ca. 300 nm tief.

Zur Erzeugung von ersten Spacern Sp1 an Flanken der ersten vorläufigen Graben GV1 wird in einem TEOS-Verfahren *SiO*₂ konform in einer Dicke von ca. 125 nm abgeschieden und anisotrop rückgeätzt (siehe Figur 3).

Anschließend wird Polysilizium in einer Dicke von ca. 500 nm abgeschieden. Durch chemisch-mechanisches Polieren wird Polysilizium entfernt, bis das Polysilizium außerhalb der ersten vorläufigen Gräben GV1 entfernt wird. Anschließend wird das Polysilizium bis zu einer Tiefe von ca. 150 nm zurückgeätzt. Dadurch entstehen streifenförmige Strukturen St aus Polysilizium. Die streifenförmigen Strukturen St weisen eine Weite auf, die mit ca. 250 nm kleiner als die minimale in der verwendeten Technologie herstellbare Strukturgröße F ist (siehe Figur 3).

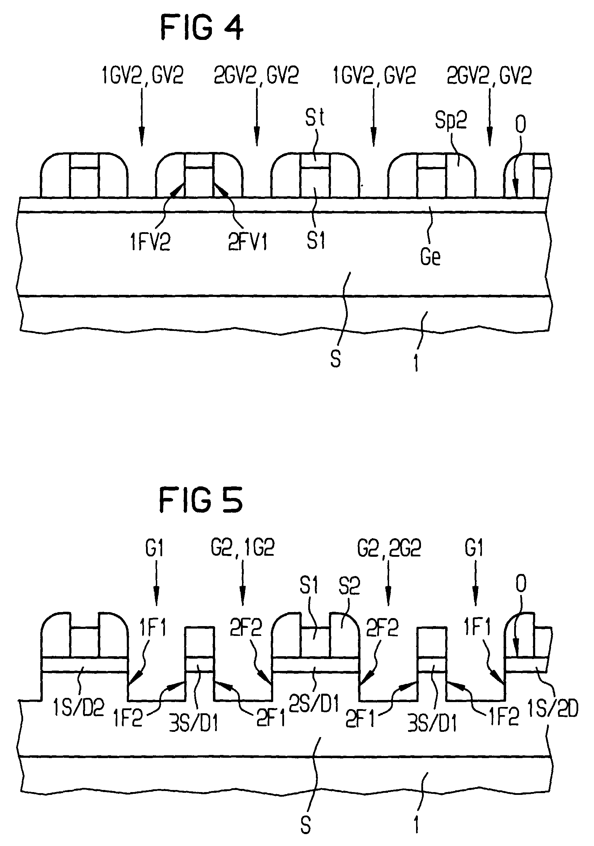

Zur Erzeugung zweiter vorläufiger Gräben GV2 werden durch anisotropes Ätzen von *SiO*₂ selektiv zu Silizium Teile der Oberfläche O freigelegt. Die zweiten vorläufigen Gräben GV2 teilen sich in abwechselnd nebeneinander angeordnete erste zweite vorläufige Gräben 1GV2 und zweite zweite vorläufige Gräben 2GV2 auf (s. Figur 4).

Durch Abscheiden von ca. 250 nm *SiO*₂ in einem TEOS-Verfahren und anschließendem anisotropen Rückätzen werden an Flanken der zweiten vorläufigen Gräben GV2 zweite Spacer Sp2 erzeugt (s. Fig 4).

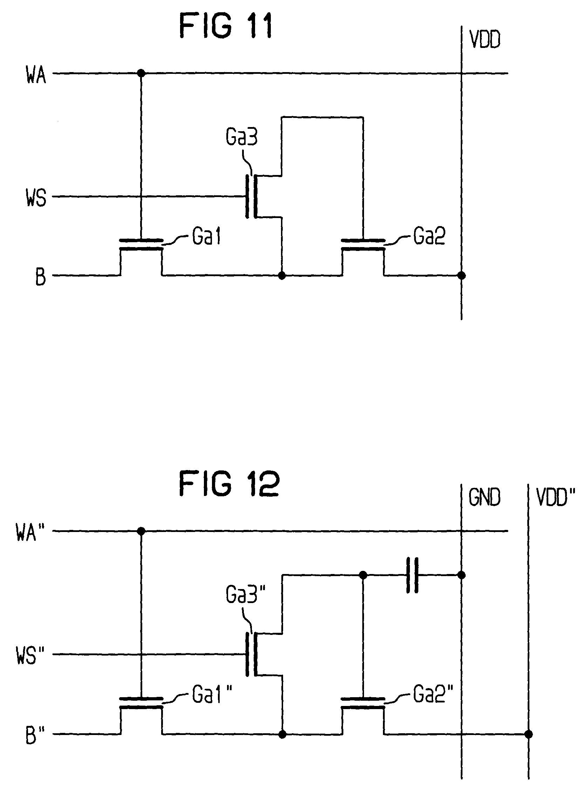

Mit Hilfe einer dritten Maske aus Fotolack (nicht dargestellt) werden durch einen anisotropen Ätzschritt zweite Spacer Sp2 an zweiten Flanken 1FV2 der ersten zweiten vorläufigen Gräben 1GV2 und an den zweiten Flanken 1FV2 der ersten zweiten vorläufigen Gräben 1GV2 gegenüberliegenden ersten Flanken 2FV1 der zweiten zweiten vorläufigen Gräben 2GV2 entfernt (s. Fig. 5). Mit z.B. HBr+NF₃+He+O₂ wird Silizium selektiv zu *SiO*₂ bis zu einer Tiefe von ca. 600 nm geätzt. Dadurch entstehen erste Gräben G1 und zweite Gräben G2. Die zweiten Gräben G2 teilen sich in erste zweite Gräben 1G2 und zweite zweite Gräben 2G2 auf. Die ersten Gräben G1 sind jeweils zu einem der ersten Gräben G1 und zu einem der ersten zweiten Gräben 1G2 oder zu einem der zweiten zweiten Gräben 2G2 benachbart. Die ersten zweiten Gräben 1G2 sind jeweils zu einem der ersten Gräben G1 und zu einem der zweiten zweiten Gräben 2G2 benachbart (siehe Figur 5). Ein Abstand zwischen Mittellinien zweier benachbarten ersten Gräben G1 und ein Abstand zwischen Mittellinien zweier benachbarten zweiten Gräben G2 sind größer als ein Abstand zwischen einer Mittellinie eines ersten Grabens G1 und einer Mittellinie eines dem ersten Graben G1 benachbarten zweiten Grabens G2 und betragen ca 750 nm. Aus dem Gebiet Ge entstehen dadurch zweite Source/Drain-Gebiete von ersten Transistoren, die an erste Flanken 1F1 der ersten Gräben angrenzen, erste Source/Drain-Gebiete von dritten Transistoren 3S/D1, die an zweite Flanken 1F2 der ersten Gräben G1 und an erste Flanken 2F1 der zweiten Gräben G2 angrenzen, und erste Source/Drain-Gebiete 2S/D1 von zweiten Transistoren, die an zweite Flanken 2F2 der zweiten Gräben G2 angrenzen. Entlang eines zweiten Grabens G2 benachbarte ersten Source/Drain-Gebiete 2S/D1 der zweiten Transistoren sind miteinander und mit einem VDD-Spannungsanschluß VDD verbunden (siehe Figur 11).

Anschließend werden durch Implantation mit Hilfe einer vierten Maske aus Fotolack (nicht dargestellt) und anschließendem Tempern n-dotierte Kontaktgebiete K erzeugt (s. Fig. 6). Dazu deckt die vierte Maske die horizontalen Bereiche Bh nicht ab. Durch den geringen Abstand zwischen dem ersten Graben G1 und dem zum ersten Graben G1 benachbarten zweiten Graben G2 grenzen die Kontaktgebiete K jeweils an einen Boden eines ersten Grabens G1 und an einen Boden eines zweiten Grabens G2 an. Die Dotierstoffkonzentration der Kontaktgebiete K beträgt ca. 5*x*10²⁰*cm*⁻³. Teile der Kontaktgebiete K, die an Böden der ersten Gräben G1 und an die ersten Flanken 1F1 der ersten Gräben G1 angrenzen, sind als erste Source/Drain-Gebiete 1 S/D1 der ersten Transistoren geeignet. Teile der Kontaktgebiete K, die an die Böden der ersten Gräben G1 und an die zweiten Flanken 1F2 der ersten Gräben G1 angrenzen, sind als zweite Source/Drain-Gebiete 3 S/D2 der dritten Transistoren geeignet. Teile der Kontaktgebiete K, die an Böden der zweiten Gräben G2 und an die zweiten Flanken 2F2 der zweiten Gräben G2 angrenzen, sind als zweite Source/Drain-Gebiete 2 S/D2 der zweiten Transistoren geeignet (siehe Figur 6).

Mit Hilfe einer fünften Maske aus Fotolack (nicht dargestellt), die Bereiche, die zwischen den horizontalen Bereichen Bh liegen, sowie die ersten Flanken 2F1 der ersten zweiten Gräben 1G2 nicht bedeckt, werden durch schräge Implantation an die ersten Flanken 2F1 der ersten zweiten Gräben 1G2 angrenzende p-dotierte erste Channel-Stop-Gebiete C1 erzeugt (s. Fig. 6). Mit Hilfe einer sechsten Maske aus Fotolack (nicht dargestellt), die Bereiche, die zwischen den horizontalen Bereichen Bh liegen, sowie die ersten Flanken 2F1 der zweiten zweiten Gräben 2G2 nicht bedeckt, werden durch schräge Implantation an die ersten Flanken 2F1 der zweiten zweiten Gräben 2G2 angrenzende p-dotierte zweite Channel-Stop-Gebiete C2 erzeugt (s. Fig. 6). Die ersten Channel-Stop-Gebiete C1 und die zweiten Channel-Stop-Gebiete C2 bilden gemeinsam Channel-Stop-Gebiete C (s. Fig. 6). Der Dotierstoff wird durch Rapid-Thermal-Annealing aktiviert. Die Dotierstoffkonzentration der Channel-Stop-Gebiete C beträgt ca. 10¹⁹cm⁻³ und ist höher als die Dotierstoffkonzentration der Schicht S.

In einem isotropen Ätzschritt werden übrigbleibende Teile der isolierenden Schicht S1 und übrigbleibende Teile der zweiten Spacer Sp2 entfernt (s. Fig. 6). Als Ätzmittel ist z.B. HF geeignet.

Durch thermische Oxidation wird ein ca. 15 nm dickes Gatedielektrikum Gd erzeugt (siehe Figur 6).

Anschließend wird in einer Dicke von ca. 125 nm dotiertes Polysilizium abgeschieden. Darüber wird konform in einem TEOS-Verfahren *SiO*₂ in einer Dicke von ca. 400 nm abgeschieden. Durch chemisch-mechanisches Polieren wird *SiO*₂ entfernt, bis das *SiO*₂ außerhalb der ersten Gräben G1 und der zweiten Gräben G2 entfernt wird. Anschließend wird mit Hilfe einer siebten Maske aus Fotolack (nicht dargestellt), die die zweiten Gräben G2 nicht bedeckt, *SiO*₂ selektiv zu Silizium geätzt, bis *SiO*₂ aus den zweiten Gräben G2 entfernt wird .Nach Entfernen der siebten Maske wird dotiertes Polysilizium in einer Dicke von ca. 400nm abgeschieden, wodurch die zweiten Gräben G2 mit Polysilizium gefüllt werden, und chemisch-mechanisch poliert, bis das SiO₂ in den ersten Gräben G1 freigelegt wird . Anschließend wird SiO₂ aus den ersten Gräben G1 durch isotropes Ätzen entfernt. Durch Rückätzen von Polysilizium hochselektiv zu SiO₂ entstehen an den ersten Flanken 1F1 der ersten Gräben G1 auslesende Wortleitungen WA in Form von Spacern und an den zweiten Flanken 1F2 der ersten Gräben G1 schreibende Wortleitungen WS in Form von Spacern (s. Fig. 6). Als hochselektives Ätzmittel ist z.B. C₂F₆+O₂ geeignet. Mit Hilfe einer achten Maske aus Fotolack (nicht dargestellt), die erste Teile der zweiten Gräben G2, die sich in den zwischen den horizontalen Bereichen Bh liegenden Bereichen befinden, nicht bedeckt, wird Polysilizium aus den ersten Teilen der zweiten Gräben G2 durch hochselektives Ätzen entfernt. Übrigbleibende Teile von Polysilizium in den zweiten Gräben G2 sind als zweite Gateelektroden Ga2 der zweiten Transistoren geeignet (siehe Figur 6).

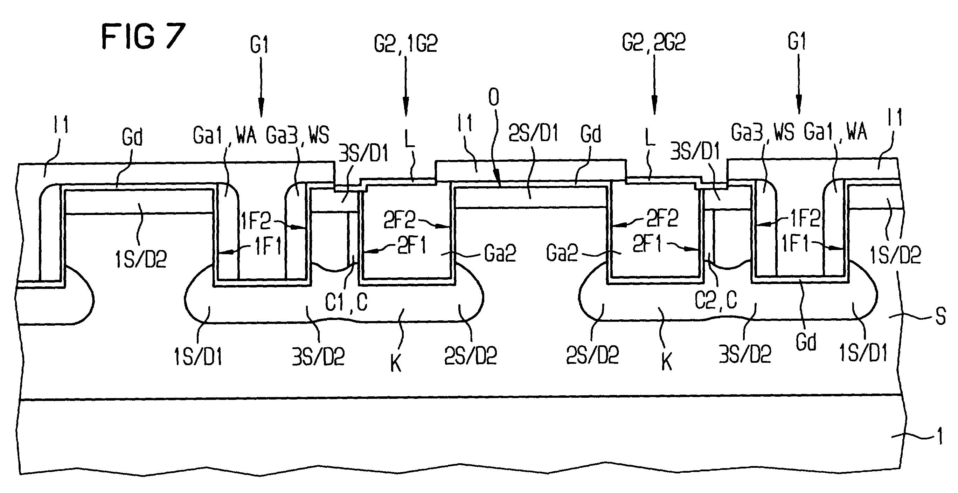

In einem TEOS-Verfahren wird in einer Dicke von ca. 500 nm *SiO*₂ abgeschieden und durch chemisch-mechanisches Polieren planarisiert. Dabei wird ca. 400nm *SiO*₂ abgetragen. Zur Erzeugung von ersten isolierenden Strukturen I1 wird mit Hilfe einer neunten Maske aus Fotolack (nicht dargestellt), die die ersten Flanken 2F1 der zweiten Gräben G2 nicht bedeckt, *SiO*₂ geätzt, bis Teile der ersten Source/Drain-Gebiete 3 S/D1 der dritten Transistoren freigelegt werden (siehe Figur 7).

Anschließend wird Titan abgeschieden und durch eine Temperung teilweise siliziert. Dadurch entstehen leitende Strukturen L. Übrigbleibendes Titan wird mit z.B. NH₃+H₂O₂ durch Ätzen entfernt (siehe Figur 7).

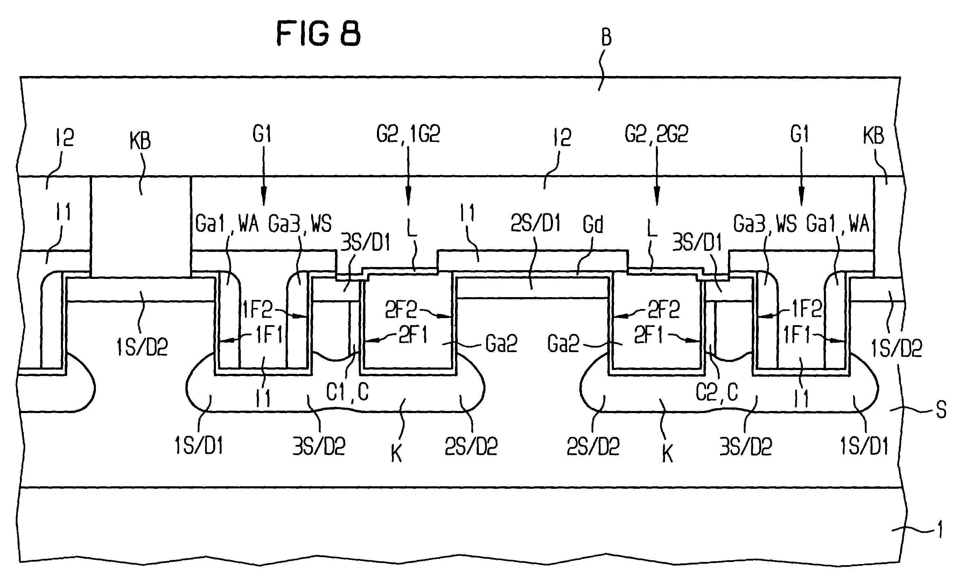

Anschließend wird zur Erzeugung einer zweiten isolierenden Struktur I2 *SiO*₂ in einer Dicke von 500 nm abgeschieden. Mit Hilfe einer zehnten Maske aus Fotolack (nicht dargestellt) wird *SiO*₂ geätzt, so, daß Teile der zweiten Source/Drain-Gebiete 1 S/D2 der ersten Transistoren freigelegt werden. Anschließend wird Wolfram abgeschieden und rückgeätzt, wodurch Kontakte KB von zu erzeugenden Bitleitungen B erzeugt werden. Durch Abscheidung von AlSiCu in einer Dicke von z.B. 500 nm und Strukturierung mit Hilfe einer elften Maske aus Fotolack (nicht dargestellt), die die horizontalen Bereiche Bh bedeckt, werden die Bitleitungen B erzeugt (siehe Figur 8).

Eine Speicherzelle umfaßt einen der ersten Transistoren, einen der zweiten Transistoren und einen der dritten Transistoren.

Zum Programmieren der Speicherzelle werden der erste Transistor über die mit ihm verbundene auslesende Wortleitung WA und der dritte Transistor über die mit ihm verbundene schreibende Wortleitung WS angesteuert. Abhängig vom eingestellten Potential an der zugehörigen Bitleitung B, von der der erste Transistor und der zweite Transistor Teile sind, wird eine Ladung, die die Information darstellt, auf die Gateelektrode des zweiten Transistors Ga2 aufgebracht (siehe Figur 11).

Zum Auslesen der Speicherzelle wird der erste Transistor über die auslesende Wortleitung WA angesteuert. Abhängig von der gespeicherten Ladung auf der Gateelektrode des zweiten Transistors Ga2 , ist der zweite Transistor geöffnet oder nicht und es fließt Strom durch die Bitleitung B oder nicht (siehe Figur 11).

In einem zweiten Ausführungsbeispiel ist ein zweites Substrat 1' aus Silizium in einer an eine Oberfläche 0' des zweiten Substrats 1' angrenzenden ca. 2 µm dicken Schicht S' p-dotiert. Die Dotierstoffkonzentration beträgt ca. 10¹⁷cm⁻³. Analog zum ersten Ausführungsbeispiel werden erste Source/Drain-Gebiete 2 S/D1' von zweiten Transistoren, erste Source/Drain-Gebiete 3 S/D1' von dritten Transistoren, zweite Source/Drain-Gebiete 1 S/D2' von ersten Transistoren, erste Gräben G1', zweite Gräben G2', ein Gatedielektrikum Gd', erste Gateelektroden Ga1' der ersten Transistoren, zweite Gateelektroden Ga2' der zweiten Transistoren, dritte Gateelektroden Ga3' der dritten Transistoren, schreibende Wortleitungen WS', auslesende Wortleitungen WA', Channel-Stop-Gebiete C' und erste isolierende Strukturen I1' erzeugt. Anschließend wird Wolfram in einer Dicke von ca. 400 nm abgeschieden und durch chemisch-mechanisches Polieren strukturiert, wodurch leitende Strukturen L' entstehen (s. Fig. 9). Anschließend werden analog wie im ersten Ausführungsbeispiel zweite isolierende Strukturen I2', Kontakte KB' von Bitleitungen B' und Bitleitungen B' erzeugt.

In einem dritten Ausführungsbeispiel ist ein drittes Substrat 1'' aus Silizium in einer an eine Oberfläche O'' des dritten Substrats 1'' angrenzenden ca. 2 µm dicken Schicht S'' p-dotiert. Die Dotierstoffkonzentration beträgt ca. 10¹⁷cm⁻³. Analog zum zweiten Ausführungsbeispiel werden erste Source/Drain-Gebiete 2 S/D1'' von zweiten Transistoren, erste Source/Drain-Gebiete 3 S/D1'' von dritten Transistoren, zweite Source/Drain-Gebiete 1 S/D2'' von ersten Transistoren, erste Gräben G1'', zweite Gräben G2'', ein Gatedielektrikum Gd'', erste Gateelektroden Ga1'' der ersten Transistoren, zweite Gateelektroden Ga2'' der zweiten Transistoren, dritte Gateelektroden Ga3'' der dritten Transistoren, schreibende Wortleitungen WS'', auslesende Wortleitungen WA'', Channel-Stop-Gebiete C'', erste isolierende Strukturen I1'' und leitende Strukturen L'' erzeugt.

Dem schließt sich ein Prozeß zur Erzeugung von Stapelkondensatoren nach dem Stand der Technik an (siehe z.B. EP 0415530B1). Der Prozeß beinhaltet die Erzeugung und Strukturierung einer Schichtenfolge oberhalb der zweiten isolierenden Strukturen I2'', die Erzeugung von seitlichen stützenden Strukturen Ss'' und die Entfernung einiger Schichten der Schichtenfolge durch selektives isotropes Ätzen. Stützenden Strukturen Ss'' mit angrenzenden übrigbleibenden Schichten der Schichtenfolge sind jeweils als erste Kondensatorplatten P1'' geeignet. Der Prozeß beinhaltet ferner die Erzeugung eines Kondensatordielektrikums Kd'' an Flächen der ersten Kondensatorplatten P1'' sowie die Abscheidung und Strukturierung von leitendem Material, wie z.B. dotiertem Polysilizium, zur Erzeugung zweiter Kondensatorplatten P2'' (s. Fig. 10). Zweite Kondensatorplatten P2'' von entlang des zweiten Grabens G2'' benachbarter Kondensatoren sind miteinander verbunden und an einen Ground-Anschluß GND angeschlossen.

Nach der Erzeugung der Stapelkondensatoren werden analog zum zweiten Ausführungsbeispiel zweite isolierende Strukturen I2'', Kontakte KB'' von Bitleitungen B'' und Bitleitungen B'' erzeugt. Wie in den vorigen Ausführungsbeispielen ist ein VDD-Spannungsanschluß VDD'' vorgesehen. Jeweils zwei zweite Kondensatorplatten P2'' von entlang der Bitleitung B'' benachbarten Kondensatoren sind miteinander verbunden.

Eine Speicherzelle umfaßt einen der ersten Transistoren, einen der zweiten Transistoren, einen der dritten Transistoren und einen der Stapelkondensatoren. Das Programmieren und Auslesen der Speicherzelle erfolgt wie im ersten Ausführungsbeispiel, wobei die Ladung, die die Information darstellt, nicht nur in der Gateelektrode des zweiten Transistors Ga2'' sondern auch in dem Stapelkondensator gespeichert ist (siehe Figur 12).

Es sind viele Variationen der Ausführungsbeispiele denkbar, die ebenfalls im Rahmen der Erfindung liegen. Insbesondere können die Abmessungen der beschriebenen Schichten, Gebiete, Bereiche und Gräben an die jeweiligen Erfordernisse angepaßt werden. Dasselbe gilt auch für die vorgeschlagenen Dotierstoffkonzentrationen. Strukturen und Schichten aus SiO₂ können insbesondere durch thermische Oxidation oder durch ein Abscheidungsverfahren erzeugt werden. Polysilizium kann sowohl während als auch nach der Abscheidung dotiert werden. Statt dotiertem Polysilizium lassen sich auch z.B. Metallsilizide und/oder Metalle verwenden. Statt abgeschiedenes Material, wie SiO₂, Wolfram, Polysilizium, durch chemisch-mechanisches Polieren abzutragen, kann auch rückgeätzt werden. Als Material für die Kondensatordielektrika eignen sich vor allem Dielektrika mit hohen Dielektrizitätskonstanten, wie z.B. Perovskite. Der Kondensator kann auch als Plattenkondensator realisiert werden.

## Patentansprüche

1. DRAM-Zellenanordnung,
- mit Speicherzellen, die jeweils einen ersten Transistor, einen zweiten Transistor und einen dritten Transistor umfassen,
- bei der eine erste Gateelektrode (Ga1) des ersten Transistors mit einer auslesenden Wortleitung (WA) verbunden ist,
- bei der ein zweites Source/Drain-Gebiet (1 S/D2) des ersten Transistors mit einer Bitleitung (B) verbunden ist,
- bei der ein erstes Source/Drain-Gebiet (1 S/D1) des ersten Transistors mit einem zweiten Source/Drain-Gebiet (3 S/D2) des dritten Transistors und mit einem zweiten Source/Drain-Gebiet (2 S/D2) des zweiten Transistors verbunden ist,
- bei der eine dritte Gateelektrode (Ga3) des dritten Transistors mit einer schreibenden Wortleitung (WS) verbunden ist,
- bei der ein erstes Source/Drain-Gebiet (3 S/D1) des dritten Transistors mit einer zweiten Gateelektrode (Ga2) des zweiten Transistors verbunden ist,
- bei der ein erstes Source/Drain-Gebiet (2 S/D1) des zweiten Transistors mit einem Spannungsanschluß verbunden ist,
- bei der der erste Transistor und/oder der zweite Transistor und/oder der dritte Transistor vertikale Transistoren sind.

2. DRAM-Zellenanordnung nach Anspruch 1,
- bei der der erste Transistor, der zweite Transistor und der dritte Transistor vertikale MOS-Transistoren sind,
- bei der der erste Transistor an einer ersten Flanke (1F1) eines in einem Substrat (1) aus Halbleitermaterial befindlichen ersten Grabens (G1), der zweite Transistor an einer zweiten Flanke (2F2) eines zum ersten Graben (G1) parallel verlaufenden zweiten Grabens (G2) und der dritte Transistor an einer zweite Flanke (1F2) des ersten Grabens (G1) angeordnet sind,
- bei der die erste Flanke (1F1) des ersten Grabens (G1) und die zweite Flanke (1F2) des ersten Grabens (G1) mit einem Gatedielektrikum (Gd) versehen sind,
- bei der die auslesende Wortleitung (WA) als Spacer entlang der ersten Flanke (1F1) des ersten Grabens (G1) angeordnet ist,
- bei der die schreibende Wortleitung (WS) als Spacer entlang der zweiten Flanke (1F2) des ersten Grabens (G1) angeordnet ist,
- bei der die erste Gateelektrode (Ga1) des ersten Transistors Teil der auslesenden Wortleitung (WA) ist,
- bei der die dritte Gateelektrode (Ga3) des dritten Transistors Teil der schreibenden Wortleitung (WS) ist,
- bei der eine erste Flanke (2F1) des zweiten Grabens (G2) und die zweite Flanke (2F2) des zweiten Grabens (G2) mit dem Gatedielektrikum (Gd) versehen sind,
- bei der die zweite Gateelektrode (Ga2) des zweiten Transistors an der zweiten Flanke (2F2) des zweiten Grabens (G2) angeordnet ist,
- bei der ein Kontaktgebiet (K) an einen Boden des ersten Grabens (G1) und an den Boden des zweiten Grabens (G2) innerhalb des Substrats (1) angrenzt,
- bei der das erste Source/Drain-Gebiet (1 S/D1) des ersten Transistors, das zweite Source/Drain-Gebiet (3 S/D2) des dritten Transistors und das zweite Source/Drain-Gebiet (2 S/D2) des zweiten Transistors Teile des Kontaktgebietes (K) sind,
- bei der Kontaktgebiete (K), zweite Gateelektroden (Ga2) zweiter Transistoren sowie leitende Strukturen (L) benachbarter Speicherzellen voneinander isoliert sind,
- bei der das zweite Source/Drain-Gebiet (1 S/D2) des ersten Transistors an einen Kontakt (KB) der Bitleitung (B) und an die erste Flanke (1F1) des ersten Grabens (G1) angrenzt,
- bei der das erste Source/Drain-Gebiet (2 S/D1) des zweiten Transistors an die zweite Flanke (2 F2) des zweiten Grabens (G2) angrenzt,
- bei der erste Source/Drain-Gebiete (2 S/D1) von entlang des zweiten Grabens (G2) benachbarter zweiter Transistoren miteinander verbunden sind,
- bei der die Bitleitung (B) quer zu der schreibenden Wortleitung (WS) verläuft und an den Kontakt (KB) angrenzt.

3. DRAM-Zellenanordnung nach Anspruch 2,
- bei der eine leitende Struktur (L) die zweite Gateelektrode (Ga2) des zweiten Transistors mit dem ersten Source/Drain-Gebiet (3 S/D1) des dritten Transistors verbindet,
- bei der die leitende Struktur (L) oberhalb der Oberfläche O an die zweite Gateelektrode (Ga2) des zweiten Transistors und an das erste Source/Drain-Gebiet (3 S/D1) des dritten Transistors angrenzt.

4. DRAM-Zellenanordnung nach Anspruch 2 oder 3,
- bei der das erste Source/Drain-Gebiet (1 S/D1) des ersten Transistors, das zweite Source/Drain-Gebiet (1 S/D2) des ersten Transistors, das erste Source/Drain-Gebiet (2 S/D1) des zweiten Transistors, das zweite Source/Drain-Gebiet (2 S/D2) des zweiten Transistors, das erste Source/Drain-Gebiet (3 S/D1) des dritten Transistors, das zweite Source/Drain-Gebiet (3 S/D2) des dritten Transistors und das Kontaktgebiet (K) von einem ersten Leitfähigkeitstyp dotiert sind,
- bei der das Substrat (1) in einer an eine Oberfläche (O) des Substrats (1) angrenzenden Schicht (S) von einem zweiten, zum ersten Leitfähigkeitstyp entgegengesetzten Leitfähigkeitstyp dotiert ist,
- bei der die Schicht (S) eine erste Dotierstoffkonzentration aufweist,
- bei der Channel-Stop-Gebiete (C) entlang der ersten Flanke (2F1) des zweiten Grabens (G2) und zwischen entlang des ersten Grabens (G1) benachbarten ersten Gateelektroden (Ga1) der ersten Transistoren und dritten Gateelektroden (Ga3) der dritten Transistoren an der ersten Flanke (1F1) und an der zweiten Flanke (1F2) des ersten Grabens (G1) innerhalb des Substrats (1) angeordnet sind,
- bei der die Channel-Stop-Gebiete (C) vom zweiten Leitfähigkeitstyp dotiert sind und eine zweite Dotierstoffkonzentration aufweist, die höher als die erste Dotierstoffkonzentration ist.

5. DRAM-Zellenanordnung nach einem der Ansprüche 1 bis 4,
- bei der der Abstand zwischen dem ersten Graben (G1) und dem zweiten Graben (G2) kleiner ist als Abstände zwischen Gräben benachbarter Speicherzellen.

6. DRAM-Zellenanordnung nach einem der Ansprüche 2 bis 5,
- bei der entlang der Bitleitung (B) benachbarte Speicherzellen bezüglich einer Achse, die parallel zum ersten Graben (G1) und innerhalb des ersten Source/Drain-Gebiets (2 S/D1) des zweiten Transistors verläuft, achsensymmetrisch gebildet sind.

7. DRAM-Zellenanordnung nach einem der Ansprüche 1 bis 6,
- bei der Speicherzellen jeweils einen Kondensator umfassen,
- bei der der Kondensator eine erste Kondensatorplatte (P1), eine zweite Kondensatorplatte (P2) und ein zwischen der ersten Kondensatorplatte (P1) und der zweiten Kondensatorplatte (P2) angeordnetes Kondensatordielektrikum (Kd) umfaßt,
- bei der die erste Kondensatorplatte (P1) mit der zweiten Gateelektrode (Ga2) des zweiten Transistors verbunden ist.

8. DRAM-Zellenanordnung nach Anspruch 7,
- bei der der Kondensator als ein Stapelkondensator ausgebildet ist,
- bei der die erste Kondensatorplatte (P1) an die leitende Struktur (L) angrenzt und oberhalb der Oberfläche (O) angeordnet ist,
- bei der zweite Kondensatorplatten (P2) von entlang des zweiten Grabens (G2) benachbarter Kondensatoren verbunden sind,
- bei der jeweils zwei zweite Kondensatorplatten (P2) von entlang der Bitleitung (B) benachbarten Kondensatoren verbunden sind.

9. Verfahren zur Herstellung einer DRAM-Zellenanordnung,
- bei dem in einem Substrat (1) erste Gräben (G1) und zweite Gräben (G2) erzeugt werden, die im wesentlichen parallel zueinander verlaufen,
- bei dem voneinander isolierte Kontaktgebiete (K) erzeugt werden, die jeweils sowohl an einen Boden eines der ersten Gräben (G1) als auch an einen Boden eines der zweiten Gräben (G2) innerhalb des Substrats (1) angrenzen,
- bei dem als Teile einer Speicherzelle ein erster vertikaler Transistor an einer ersten Flanke (1F1) des ersten Grabens (G1), ein zweiter vertikaler Transistor an einer zweiten Flanke (2F2) des zweiten Grabens (G2) und ein dritter vertikaler Transistor an einer zweiten Flanke (1F2) des ersten Grabens (G1) gebildet werden, wobei eines der Kontaktgebiete (K) als erstes Source/Drain-Gebiet des ersten Transistors (1S/D1), als zweites Source/Drain-Gebiet (2S/D2) des zweiten Transistors und als zweites Source/Drain-Gebiet des dritten Transistors (3S/D2) dient,
- bei dem zur Erzeugung der drei Transistoren die erste Flanke (1F1) und die zweite Flanke (1F2) des ersten Grabens (G1) und die erste Flanke (2F1) und die zweite Flanke (2F2) des zweiten Grabens (G2) mit einem Gatedielektrikum (Gd) versehen werden,
- bei dem eine erste Gateelektrode (Ga1) des ersten Transistors als Teil einer auslesenden Wortleitung (WA) innerhalb des ersten Grabens (G1) als Spacer an die erste Flanke (1F1) des ersten Grabens (G1) angrenzend gebildet werden,
- bei dem eine dritte Gateelektrode (Ga3) des dritten Transistors als Teil einer schreibenden Wortleitung (WS) innerhalb des ersten Grabens (G1) als Spacer an die zweite Flanke des ersten Grabens (G1) angrenzend gebildet werden,
- bei dem eine zweite Gateelektrode (Ga2) des zweiten Transistors innerhalb eines zweiten Grabens (G2) an die zweite Flanke (2F2) des zweiten Grabens (G2) angrenzend gebildet wird,
- bei dem eine quer zur auslesenden Wortleitung (WA) und zur schreibenden Wortleitung (WS) verlaufende Bitleitung (B) erzeugt und mit einem zweiten Source/Drain-Gebiet (1S/D2) des ersten Transistors verbunden wird.

10. Verfahren nach Anspruch 9,
- bei dem das Substrat (1), das Halbleitermaterial enthält, in einer an die Oberfläche (O) angrenzenden Schicht (S) von einem zweiten Leitfähigkeitstyp mit einer ersten Dotierstoffkonzentration dotiert wird,
- bei dem innerhalb des Substrats (1) entlang der ersten Flanke (2F1) des zweiten Grabens (G2) und zwischen entlang des ersten Grabens (G1) benachbarten ersten Gateelektroden (Ga1) der ersten Transistoren und dritten Gateelektroden (Ga3) der dritten Transistoren an der ersten Flanke (1F1) und an der zweiten Flanke (1F2) des ersten Grabens (G1) durch schräge Implantation vom zweiten Leitfähigkeitstyp dotierte Channel-Stop-Gebiete (C) erzeugt werden, so, daß sie eine zweite Dotierstoffkonzentration aufweisen, die höher als die erste Dotierstoffkonzentration ist.

11. Verfahren nach Anspruch 9 oder 10,
- bei dem nach Erzeugung des Gatedielektrikums (Gd) konform leitendes Material aufgebracht wird,
- bei dem anschließend isolierendes Material aufgebracht und durch chemisch-mechanisches Polieren abgetragen und planarisiert wird, so, daß das isolierende Material außerhalb der ersten Gräben (G1) und der zweiten Gräben (G2) entfernt wird, und die ersten Gräben (G1) und die zweiten Gräben (G2) mit dem isolierenden Material gefüllt werden,
- bei dem anschließend mit Hilfe einer siebten Maske das isolierende Material aus den zweiten Gräben (G2) entfernt wird,
- bei dem anschließend zum Füllen der zweiten Gräben (G2) mit leitendem Material leitendes Material abgeschieden und abgetragen wird, bis das isolierende Material in den ersten Gräben (G1) freigelegt wird,
- bei dem anschließend das isolierende Material aus den ersten Gräben (G1) entfernt wird,
- bei dem anschließend das leitende Material rückgeätzt wird, so, daß in den ersten Gräben (G1) die schreibenden Wortleitungen (WS) und die auslesenden Wortleitungen (WA) in Form von Spacern entstehen,
- bei dem anschließend mit Hilfe einer achten Maske das leitende Material aus Teilen der zweiten Gräben (G2) entfernt wird, wodurch aus übrigbleibenden Teilen des leitenden Materials in den zweiten Gräben (G2) die zweiten Gateelektroden (Ga2) der zweiten Transistoren entstehen,
- bei dem anschließend zur Erzeugung von ersten isolierenden Strukturen (I1) isolierendes Material aufgebracht wird, so, daß die ersten Gräben (G1) mit isolierendem Material gefüllt werden und mit Hilfe einer neunten Maske strukturiert wird, so daß Teile von ersten Source/Drain-Gebieten (3 S/D1) der dritten Transistoren freigelegt werden.

12. Verfahren nach einem der Ansprüche 9 bis 11,
- bei dem die ersten Source/Drain-Gebiete (3 S/D1) der dritten Transistoren jeweils an die ersten Flanken (2F1) der zweiten Gräben (G2) angrenzend erzeugt werden,
- bei dem nach der Freilegung der Teile der ersten Source/Drain-Gebiete (3 S/D1) der dritten Transistoren Metall aufgebracht und durch Tempern selektiv siliziert wird, wodurch die leitenden Strukturen (L), die Metallsilizid enthalten, entstehen,
- bei dem übriggebliebenes Metall entfernt wird.

13. Verfahren nach einem der Ansprüche 9 bis 11,
- bei dem nach der Freilegung der Teile der ersten Source/Drain-Gebiete (3 S/D1) der dritten Transistoren leitendes Material aufgebracht und planarisiert wird, wodurch die leitenden Strukturen (L) entstehen.

14. Verfahren nach einem der Ansprüche 9 bis 13, bei dem der erste Graben (G1) und der zweite Graben (G2) so hergestellt werden, daß ihr Abstand voneinander kleiner ist, als Abstände zwischen Gräben jeweils verschiedener Speicherzellen.

15. Verfahren nach Anspruch 14,
- bei dem auf einer Oberfläche (O) des Substrats (1) ein erstes Material abgeschieden wird, in dem in gleichmäßigen Abständen voneinander streifenförmige, zueinander parallele erste vorläufige Gräben (GV1) erzeugt werden,
- bei dem anschließend konform mehr vom ersten Material aufgebracht und rückgeätzt wird, so, daß an Flanken der ersten vorläufigen Gräben (GV1) erste Spacer (Sp1) entstehen,
- bei dem anschließend ein zweites Material aufgebracht und rückgeätzt wird, so, daß die ersten vorläufigen Gräben (GV1) teilweise gefüllt werden,
- bei dem anschließend das erste Material geätzt wird, so, daß zweite vorläufige Gräben (GV2) entstehen und die ersten Spacer (Sp1) entfernt werden,
- bei dem anschließend mehr vom ersten Material aufgebracht und rückgeätzt wird, so, daß an Flanken der zweiten vorläufigen Gräben (GV1) zweite Spacer entstehen (Sp2),
- bei dem anschließend mit Hilfe einer dritten Maske zweite Spacer (Sp2) abwechselnd an den ersten Flanken (F1) oder an den zweiten Flanken (F2) der zweiten vorläufigen Gräben (GV2) entfernt werden,
- bei dem zur Erzeugung der ersten Gräben (G1) und der zweiten Gräben (G2) anschließend das Halbleitermaterial geätzt wird.
